# EUROPEAN PATENT APPLICATION

(11) **EP 0 917 414 A1**
(43) Date of publication of application: **19.05.1999**
(21) Application number: 98118778.4
(22) Date of filing: 05.10.1998
(51) Int. Cl.: H05K 3/12, B41F 15/08

(54) **Device for holding a substrate board for printed circuits during the screen printing process**

(30) Priority: 11.11.1997 IT MI972511
(71) Applicant: PRI.TE.MA. S.r.l., 20063 Cernusco sul Naviglio (MI) (IT)
(72) Inventor: Gherardi, Tommasina, 20129 Milan (IT)
(74) Representative: Mayer, Hans Benno, Dipl.-Ing.

(57) **Abstract**

A device for holding a printed circuit or substrate board (12) for printed circuits during the screen printing process, comprising clamps (8) for immobilizing the substrate board (12) in which the jaws (9,10) of the immobilizing clamp (8) are made wholly or partly of ferrous material and in which at least one jaw (10) of the clamp (8) is equipped with a series of permanent magnets (14).

## Description

The present invention relates to a device holding a printed circuit or substrate board for printed circuits during the screen printing process.

It is prior art to apply the design of printed circuits or the photographic solder to the circuit by a screen printing process.

In this process the substrate boards are conveyed and processed in a vertical position. In order to print the substrate boards on both sides using frames for the screen printing, the substrate boards contain carrying holes in the corners of the substrate board.

In order to hold the substrate board in the desired vertical position use is made of known immobilizing clamps, and always one jaw of each immobilizing clamp includes immobilizing pins that project and fit into the holes provided in the substrate board of the printed circuit.

The provision of immobilizing through holes in the substrate board of the printed circuit requires the setting up of a special machine for drilling or cutting these reference holes. Moreover the additional operation of making the holes greatly increases the manufacturing times for the substrate board.

In addition, the presence of through holes in the substrate board that is to receive the printed circuit forms undesired seats in which dust and dirt can collect.

It is therefore an object of the present invention to overcome the disadvantages inherent in the state of the art and to make possible accurate vertical printing of a substrate board that has no positioning holes, by the screen printing process.

This object is achieved with a device for holding a substrate board for printed circuits in a vertical screen printing installation, comprising clamps for immobilizing the substrate board, and in which the jaws of the immobilizing clamp are made of ferrous material and in which at least one jaw of the clamp is equipped with permanent magnets.

With a clamp having these features it will be possible to dispense with positioning holes in the corners of the substrate board of the printed circuit and the immobilizing clamps can be constructed without positioning pins.

Owing to the provision of one or more bodies consisting of permanent magnets and to the fact that the clamp is made of ferrous material, after the substrate board has been introduced between the open jaws and the jaws then closed, the jaws are held firmly in the closed position by the action of the magnetic forces generated by the permanent magnets, which tend to pull the ferrous clamp jaw containing no magnetic inserts toward the jaw of the clamp containing magnetic bodies.

The subject devised in accordance with the present invention will now be described in greater detail in the form of an embodiment given purely by way of example and illustrated in the accompanying drawings, in which:
Figure 1 shows schematically a device for screen printing substrate boards for printed circuits;
Figure 2 shows schematically two clamps for immobilizing the substrate board, in the closed position and, separately, in the open position; and
Figure 3 shows schematically, in perspective, two open clamps with the jaws fitted with bodies formed by permanent magnets.

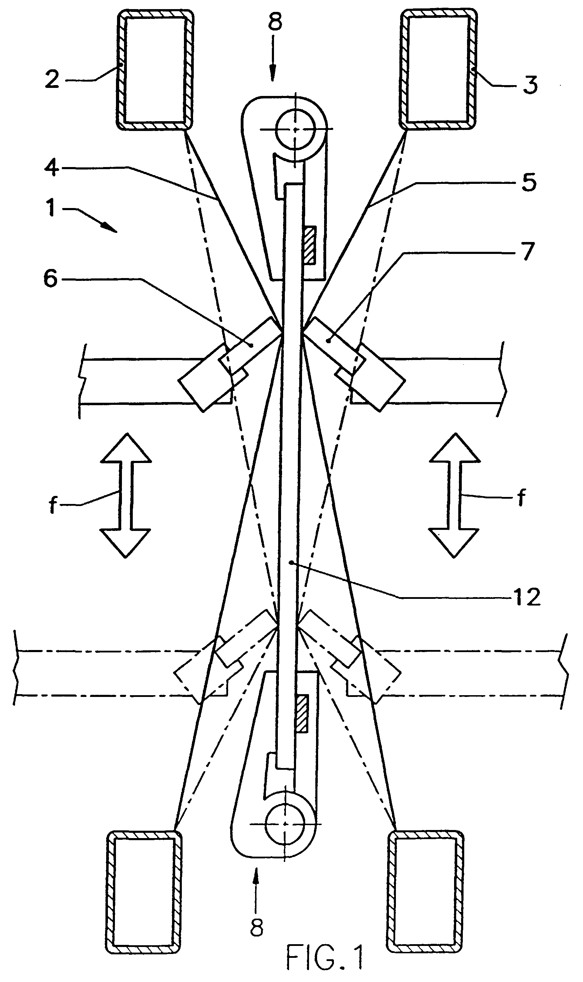

As can be seen in Figure 1, the vertical screen printing device, which bears the general reference 1, includes a known printing frame 2 and a known printing frame 3.

Each printing frame 2, 3 contains a known printing screen 4, 5 which is wiped by known squeegees 6 and 7 that move up and down as indicated by the arrow f during printing. It is the squeegees 6, 7 that apply the printed circuit design to the surfaces of a substrate board 12.

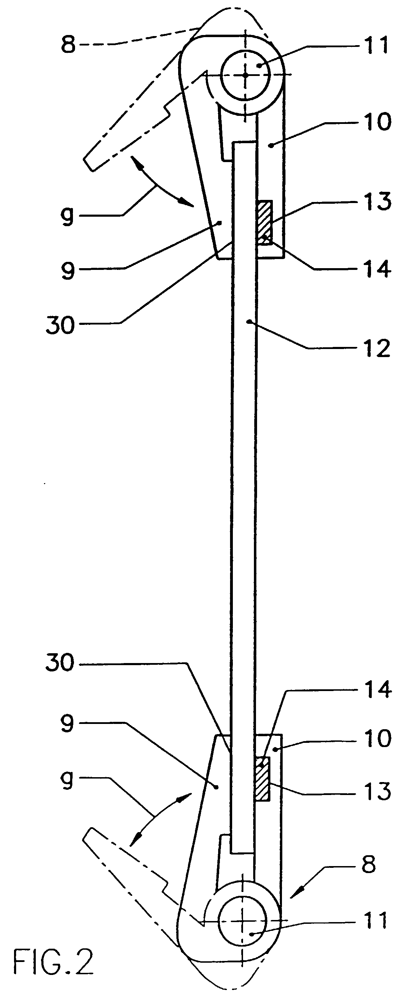

Situated close to the upper edge and lower edge of the printing frames 2, 3 are clamping devices bearing the general reference 8. The devices 8 are described in greater detail with the aid of Figure 2. Each clamp 8 is composed of two jaws 9, 10, and jaw 9 can pivot (in the sense indicated by the arrows g) around a pivot pin marked 11.

The substrate board marked 12 is positionable automatically between the clamps 9 and 10 of the jaws 8.

The jaws 10 of the clamps 8 include seats 13 extending at intervals along the entire length of the jaw 10.

The seats 13 advantageously are located in the vicinity of the free edge of the jaw 10.

The seats 13 contain small permanent magnets 14 which advantageously take the form of small disks 14.

The permanent magnets are either fixed in the seats 13 of the jaw 10 by a pressure fit or these permanent magnets 14 are bonded adhesively in the seats 13.

The jaw 9 is made of ferrous material or includes at least some parts made of ferrous material.

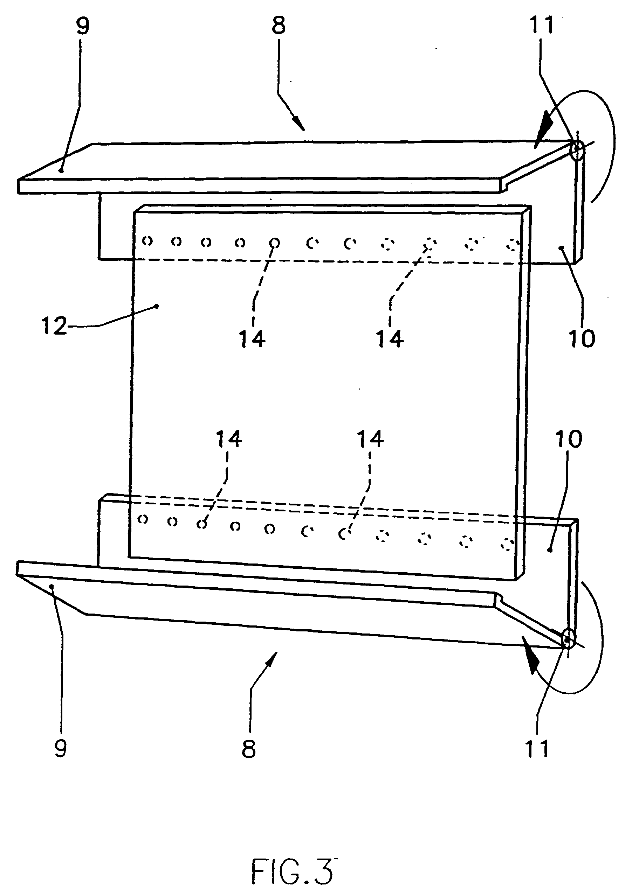

Visible schematically in Figure 3 are two clamps 8 and 9 situated along the upper edge and lower edge of the substrate board 12 that is to be printed by the screen process.

The free edge of the jaw 10 contains the permanent magnets 14 in the form of small disks or plates fixed firmly in the jaw 10. With particular advantage the inside surfaces 30 of the jaws 9 may have a surface provided with small asperities or other surface irregularities, for the purpose of enhancing the gripping action of the clamp 9.

The operation of the clamps 8 proposed in accordance with the present invention is as follows.

When the substrate board 12 is inserted (with the aid of known automatic conveying and locating systems) between the jaws 9 and 10 of the open clamps 8 each jaw 9 is pivoted by actuating means known per se toward the substrate board 12 so that the surface 30 of the jaw 9 comes into contact with one side of the substrate board 12 and presses it against the opposite jaw 10.

Because of the action of the permanent magnets 14, the jaw 9 made of ferrous material or containing ferrous structural parts, is drawn by the permanent magnets 14 toward the body of the jaw 10. The result is that the substrate board 12 is securely immobilized in the closed clamp 8.

The number, arrangement and strength of the permanent magnets 14, distributed at intervals along the free edge of the jaw 10 are selected in such a way as to ensure secure immobilization of the substrate board 12 between the jaws 9 and 10 of the clamps 8. Each substrate board 12 will be immobilized with a force such as to prevent undesired movement of the substrate board 12 during the movement of the squeegees 6, 7 which carry out the screen printing operation.

## Claims

1. A device for holding a substrate board for printed circuits in a vertical screen printing installation, comprising clamps for immobilizing the substrate board, wherein the jaws (9, 10) of the immobilizing clamp (8) are made of ferrous material and wherein at least one jaw (9, 10) of the clamp is equipped with permanent magnets (14).

2. The device as claimed in claim 1, wherein one jaw (9, 10) of the clamp (8) includes seats (13) extending at intervals along the entire length of the jaw (9, 10) and wherein the seats (13) contain permanent magnets (14).

3. The device as claimed in claim 2, wherein the seats (13) containing the permanent magnets (14) are located in the vicinity of the free edge of the jaw (9, 10).

4. The device as claimed in claim 2, wherein the permanent magnets (14) are in the shape of disks or plates.

5. The device as claimed in claim 2, wherein the permanent magnets (14) are fixed in the seats (13) of the jaw (9, 10) by pressure fit.

6. The device as claimed in claim 2, wherein the permanent magnets (14) are fixed in the seats (13) of the jaw by adhesive bonding.

7. The device as claimed in claim 1, wherein only parts of the clamp (8) are made of ferrous material.

8. The device as claimed in claim 1, wherein the inside surfaces (30) of the Jaws (9, 10) of the clamp have surface irregularities in the form of small asperities.
